# EUROPEAN PATENT SPECIFICATION

(11) **EP 4 510 188 B1**
(45) Date of publication and mention of the grant of the patent: **11.02.2026**
(21) Application number: 24191129.6
(22) Date of filing: 26.07.2024
(51) Int. Cl.: H01L 25/16, H10F 55/25, H10H 29/20

(54) **METHOD AND STRUCTURE FOR SHIELDING ELECTROMAGNETIC INTEFERENCE IN PHOTONIC INTEGRATED CIRCUITS STACKED UP ELECTRONIC INTEGRATED CIRCUITS**
VERFAHREN UND STRUKTUR ZUR ABSCHIRMUNG ELEKTROMAGNETISCHER INTERFERENZEN IN AUF ELEKTRONISCHE INTEGRIERTE SCHALTUNGEN GESTAPELTEN PHOTONISCHEN INTEGRIERTEN SCHALTUNGEN
PROCÉDÉ ET STRUCTURE DE BLINDAGE CONTRE L'INTERFÉRENCE ÉLECTROMAGNÉTIQUE DANS DES CIRCUITS INTÉGRÉS PHOTONIQUES EMPILÉS SUR DES CIRCUITS INTÉGRÉS ÉLECTRONIQUES

(30) Priority: 15.08.2023 US 202318449728
(43) Date of publication of application: 19.02.2025
(73) Proprietor: Avago Technologies International Sales Pte. Limited, Singapore 768923 (SG)
(72) Inventor: Seetharam, Venkatesh, Fremont, 94539 (US); Brosnan, Mike John, Fremont, 94536 (US)
(74) Representative: Dilg, Haeusler, Schindelmann Patentanwaltsgesellschaft mbH

(56) References cited:
- US-A1- 2015 016 067
- US-A1- 2020 249 540
- US-A1- 2021 096 310
- US-A1- 2021 343 671
- US-A1- 2022 283 387

## Description

### FIELD OF INVENTION

The subject technology is directed to semiconductor devices and methods of manufacturing.

### BACKGROUND OF THE INVENTION

The process of packaging silicon photonics frequently involves the 3D stacking of Electronic IC (EIC) and Photonic IC (PIC). The PIC is typically equipped with a modulator on the transmitter (Tx) end and photo diodes at the receiver (Rx) end, with multiple channels for both transmission and reception. The PIC generally features a considerably thick bulk silicon, around 700 micrometers.

The modulator's design often includes a transmission line of a specific length and characteristic impedance. Depending on the manufacturing foundry, this transmission line might be unshielded, which can result in the emission of electric and magnetic fields. These fields can penetrate the 3D stack in all three dimensions.

Fields spreading across the X and Y dimensions can potentially be terminated by vias connected to the reference nets. However, in the Z direction, the fields can propagate without restriction within the PIC's bulk silicon, limiting the degree to which grounding can be accomplished in the Z direction.

Furthermore, a metal plate is often used on the PIC's backside for efficient heat dissipation but not electrically grounded. Such a setup can often lead to high levels of electrical coupling or crosstalk between the transmitter and receiver paths. The electromagnetic interference in PIC originates mainly from light transmission components like unshielded transmission lines to light detection components like photodetectors. Due to the lack of appropriate electric shielding, the fields from the transmission lines can be directed towards the highly sensitive photodetectors, thereby intensifying the issue.

US 2022/283387 A1, US 2020/249540 A1, US 2021/343671 A1, US 2021/096310 A1 and US 2015/016067 A1 disclose integrated circuit devices according to the prior art.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a schematic diagram of a photonic integrated circuit stacking up on an electronic integrated circuit according to some embodiments of the subject technology.
Figure 2 is a schematic diagram of a photonic integrated circuit with an electromagnetic shield based on through-silicon-vias and backside metallization stacking up on an electronic integrated circuit according to some embodiments of the subject technology.
Figure 3 is a schematic top view of a photonic integrated circuit comprising co-packaged transmitter and receiver according to an embodiment of the subject technology.
Figure 4 is a schematic perspective view of the electromagnetic shield based on through-silicon-vias and backside metallization according to an embodiment of the subject technology.
Figure 5 is plots of crosstalk isolation comparison for one Tx-Rx channel in three shielding models according to some embodiments of the subject technology.

### DETAILED DESCRIPTION OF THE INVENTION

The subject technology is directed to semiconductor devices and methods of manufacturing. In a specific embodiment, a method for shielding electromagnetic interference in silicon photonic integrated circuit is provided. The method includes forming a plurality of vias through bulk silicon substrate from reference nets at the front top to a conductive layer covering backside of the photonic integrate circuit chip. Such an arrangement allows for robust electrical connection and allows the metal heat spreader coupled to the backside to act as robust ground thus terminating the electric and magnetic fields. There are other embodiments as well.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

In an example, the term "circuit board", including the mentioned "main circuit board" and "sub-sized circuit board", also known as a printed circuit board (PCB), refer a flat, rigid board made of insulating material, typically fiberglass or plastic, that contains a complex network of metallic pathways, or "traces," that form the electrical circuitry for various electronic devices. Components such as resistors, capacitors, and integrated circuits are then mounted onto the board, and their leads are soldered onto the corresponding traces to create a functioning electronic circuit. "Main" or "sub-sized" is mainly referring to a lateral size of the circuit board, which is one of focal features of the present disclosure.

When an element is referred to herein as being "connected" or "coupled" to another element, it is to be understood that the elements can be directly connected to the other element or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present. When an element is referred to herein as being "electrically coupled" to another element, it is to be understood that the element can directly connected by an electrical conductor to another element.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer or a layer of conductive material may comprise multiple different conductive materials or multiple layers of different conductive materials, and a dielectric layer may comprise multiple dielectric materials or multiple layers of dielectric materials. A "metal layer" or a layer of metal material is merely one type of conductive layer. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, frontside, backside, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect of the present disclosure includes an integrated circuit device with electromagnetic shielding to suppress crosstalk interference. The integrated circuit device also includes a printed circuit board (PCB). The device also includes a first circuit on a first substrate which includes a first surface and a second surface, the first surface being coupled to the PCB, the second surface may include a first plurality of contacts coupled to the first circuit. The device also includes a second circuit on a second substrate which includes a third surface and a fourth surface. The second circuit includes at least a first component and a second component and is disposed on the first circuit. The third surface may include a second plurality of contacts coupled to the at least the first component and the second component. The second plurality of contacts is coupled to the first plurality of contacts. The device also includes a layer of conductive material disposed on the fourth surface. The device also includes a metal layer disposed in a dielectric between the first component and the third surface. The device also includes a first plurality of vias extended from the fourth surface through the second substrate to at least partially surround the first component, the first plurality of vias being coupled to the layer of conductive material and the metal layer. The device also includes a second plurality of vias extended from the fourth surface through the second substrate to at least partially surround the second component, the second plurality of vias being coupled to the layer of conductive material and the metal layer.

Implementations may include one or more of the following features. The device where the first component may include at least one of optical transmitter, laser, optical amplifier, and optical modulator. The first plurality of vias and the second plurality of vias may include a via-to-via pitch separation smaller than 1 mm for achieving -125dB isolation between the first component and the second component from the electromagnetic interference with a characteristic frequency up to 30 GHz. The second component may include at least one photodetector, optical receiver, and optical sensor. The device may include an electrical reference net based on the metal layer with a single ground connection. The metal layer may include a first grounded layer at least partially covering an area of the first component and a second grounded layer at least partially covering an area of the second component, the first grounded layer and the second grounded layer being isolated and having independent ground connections. The device may include a first metal plate disposed on a first portion of the fourth surface coupled to the first plurality of vias and the first grounded layer for shielding the first component, and a second metal plate disposed on a second portion of the fourth surface coupled to the second plurality of vias and the second grounded layer for shielding the second component, the second metal plate being decoupled from the first metal plate. The device may include a barrier layer disposed between the fourth surface and the layer of conductive material. The layer of conductive material may include a layer of Cu or Al or an alloy of Cu and Al or a layer of heavily doped silicon. The device may include a metal plate coupled to the layer of conductive material on the fourth surface and electrically grounded.

Another general aspect includes a method for suppressing electrical coupling in a photonics integrated circuit. The method also includes providing a substrate that may include a first surface and the second surface, the second surface being opposite to the first surface. The method also includes packaging a first photonic component and a second photonic component on the first surface. The first photonic component may include at least a light transmitter, the second photonic component may include at least a light detector. The method also includes forming an electrical reference net based on at least one metal layer positioned in a dielectric, the dielectric at least partially covering the light transmitter and the light detector. The method also includes forming a first plurality of vias from the second surface through the substrate to couple to the electrical reference net, the first plurality of vias being disposed to at least partially surround the light transmitter. The method also includes forming a conductive layer on the second surface of the substrate, the conductive layer being coupled to the first plurality of vias and the electrical reference net to form an electrical shield for the first photonic component.

Implementations may include one or more of the following features. The method also may include forming a second plurality of vias from the second surface through the substrate to couple to the electrical reference net, the second plurality of vias being disposed to at least partially surround the light detector. The method may include forming a second conductive layer on the second surface of the substrate to couple to the second plurality of vias and the electrical reference net to form an electrical shield for the second photonic component. Forming the electrical reference net may include forming a first reference net at least partially covering an area associated with the light transmitter, and forming a second reference net at least partially covering an area associated with the light detector. The first reference net and the second reference net are electrically isolated from each other and separately grounded. The method may include forming at least one first metal contact and at least one second metal contact on the first surface, the at least one first metal contact being arranged to couple to the light transmitter and the at least one second metal contact being arranged to couple to the light detector. The method may include coupling the at least one first metal contact and the at least one second metal contact respectively to corresponding contacts of an electronic integrated circuit.

Yet another general aspect includes a photonics integrated device with electromagnetic shielding. The photonics integrated device also includes a substrate with a first surface and a second surface, the second surface being opposite to the first surface. The device also includes a circuit formed on the first surface. The circuit may include at least a first component and a second component. The first component may include at least a light transmitter. The second component may include at least a light detector. The device also includes a metal layer disposed in a dielectric on the first surface. The dielectric at least partially covers the circuit. The metal layer is used as an electrical reference which is set to have a certain voltage potential level, e.g., 0V. The device also includes a first plurality of vias from the second surface through the substrate, the first plurality of vias being configured to couple to the electrical reference and to at least partially surround the first component. The device also includes a second plurality of vias from the second surface through the substrate, the second plurality of vias being configured to couple to the electrical reference and to at least partially surround the second component. The device also includes a conductive layer on the second surface of the substrate, the conductive layer is coupled to the first plurality of vias and the second plurality of vias to form a first electromagnetic shield and a second electromagnetic shield respectively for the first component and the second component.

Implementations may include one or more of the following features. The device where the first plurality of vias and the second plurality of vias may include a via-to-via pitch separation smaller than 1 mm to achieve at least -125 dB isolation between the light transmitter and the light detector to electromagnetic interference with characteristic frequencies up to 30 GHz. The metal layer may include a first section and a second section being separately grounded and respectively coupled with the first plurality of vias and the second plurality of vias. The conductive layer may include a first portion and a second portion respectively coupled with the first section and the second section to be associated with the first electromagnetic shield and the second electromagnetic shield respectively, the first electromagnetic shield being decoupled from the second electromagnetic shield. Embodiments of the subject technology are illustrated by examples shown below.

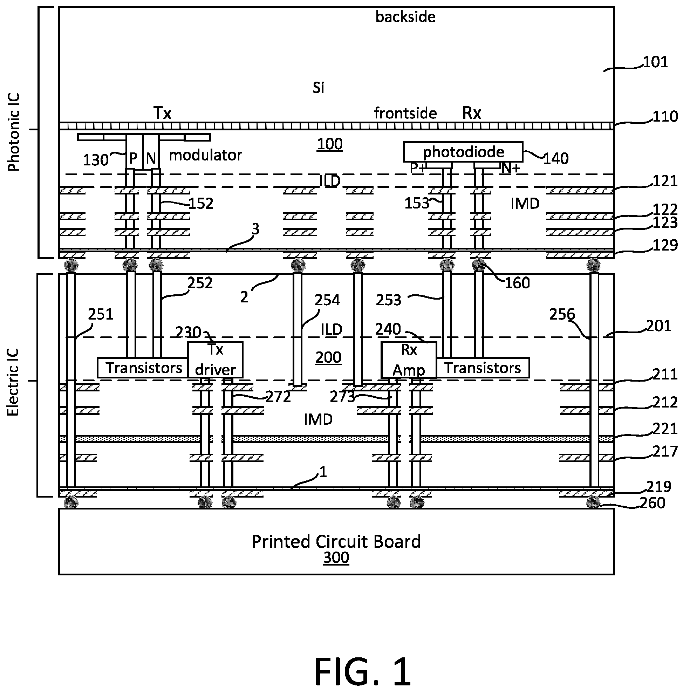

Figure 1 is a schematic diagram of a photonic integrated circuit stacking up on an electronic integrated circuit according to some embodiments of the subject technology. This diagram is merely an example, which should not unduly limit the scope of the claims. One of ordinary skill in the art would recognize many variations, alternatives, and modifications.

As shown in FIG. 1, a silicon photonics device is packaged in a form of 3D stacking of an electronic integrated circuit (EIC) 200 and a photonics integrated circuit (PIC) 100. The EIC 200, for example, may include a Tx driver subcircuit configured by one or more transistors 230 and Rx amplifier subcircuit configured by one or more transistors 240. For example, a subcircuit refers to one of the circuit components. For example, circuit 100 may include multiple subcircuits for various functions. Multiple conducting vias 272 and 273 are used to respectively couple the Tx driver subcircuit and Rx amplifier subcircuit to metal contacts 219 to form multiple electrical contacts on a first surface of EIC 200. EIC 200 is mounted on a surface of a printed circuit board (PCB) 300 by directly bonding the multiple electrical contacts on the first surface 1 by solders 260 to corresponding surface contacts on the PCB 300. There may be multiple metal layers (211, 212, 217), separated from each other by inter-metal dielectric (IMD), are disposed between a device layer (including Tx driver subcircuit and Rx amplifier subcircuit) and the first surface 1 to form all kinds of electrical signal distributions and form one or more electrical references with certain potential levels being set for the circuits in the device layer. Optionally, there may be one or more other layers 221 for circuitry layout inside the IMD. Also, several conducting vias 252 and 253 are used to couple one or more electrodes of transistors 230 and transistors 240 through an inter-layer dielectric (ILD) to a second surface 2 of EIC 200 to form a first group of electrical contacts for circuits in the EIC 200. Optionally, some conducting vias 251, 254, 256 may be used to connect one or more electrical contacts on the first surface to one or more electrical contacts on the second surface 2 for device wiring, grounding purposes, as well as electrical shielding between subcircuits in EIC 200. EIC 200, before it is mounted on the PCB 300, is formatted as a microchip with a thickness thinned down to about 65 um between the first surface 1 and the second surface 2.

The PIC 100 is based on a silicon substrate 101 with a frontside and a backside. The frontside may be referred to as first surface and the backside may be referred to second surface, the second surface being opposite to the first surface. The PIC 100 may include a first photonic subcircuit and a second photonic subcircuit co-packaged on the frontside of the silicon substrate. The first photonic subcircuit may include at least one light transmission component and the second photonic subcircuit may include at least one light detection component. Light transmission components, including light generation components like laser (and laser driver), light amplification components like optical amplifier, light modulation components like optical modulator, and optical transmitter, usually are large electromagnetic field emitters to cause high electromagnetic interference to neighboring devices. On the other hand, the light detection components including photodetectors (PDs) like photodiodes (PIN diodes or avalanche PDs), optical receivers (including signal processing), and optical sensors, usually generate low electromagnetic interference themselves but being highly sensitive to the electromagnetic interference from other circuits. In the example as shown in FIG. 1, the first photonic subcircuit includes an optical transmitter and the second photonic subcircuit includes an optical receiver. Silicon substrate 101 is characterized by a thickness greater than 700 um between the frontside and the backside, and a high resistivity of >750 ohms-cm, with desired mechanical strength and electrical properties for forming co-packaged integrated circuits and multiple discrete devices. Between the device layer and the frontside of silicon substrate, there may be a buried oxide layer 110. In some embodiments, silicon substrate 101 is a silicon-on-insulator (SOI) substrate. Of course, other types of substrates like pure silicon, silicon nitride, indium phosphide, gallium arsenide, or glass substrate can be used depending on applications.

Referring to FIG. 1, the transmitter and the receiver are co-packaged subcircuits on the frontside of silicon substrate 101. In the example, the optical transmitter includes at least a modulator 130, e.g., a Si-SiN-Si modulator with a transmission line (not shown). The optical receiver may include at least a photodiode 140, e.g., a SiGe photodiode. An inter-layer dielectric (ILD) film may overlay the PIC 100. Then, multiple metal layers, 121, 122, 123, with certain patterns are formed on the ILD film. These metal layers, separated by inter-metal dielectric (IMD), may have been engineered as electrical signal distributions for the modulator 130 and the photodiode 140. In a specific embodiment, one or more of the multiple metal layers (121, 122, 123) may be linked through internal connections to form a common electrical reference net. Optionally, the electrical reference net may comprise one or more metal layers or metal grids or networks across certain spatial range. Optionally, the electrical reference net can be set to a certain voltage level, e.g., 3.3V, or electrically grounded. The multiple metal layers may include a metal contact 129 disposed at a third surface 3, a top-most layer above the frontside of the silicon substrate. Both modulator 130 and photodiode 140 may have one or more associated electrodes respectively through one or more conducting vias 152 and 153 to connect to the metal contact 129 which is pattered to form a second group of electrical contacts on the third surface 3 of PIC 100.

In general, an electrical reference, often referred to as a reference plane or reference net, is a stable point of known voltage against which other electrical potentials are measured. This reference is crucial in the design and analysis of electronic circuits and systems. In some embodiments, this reference net is a "ground" or "common" node in a circuit physically connecting part of an electrical system to the Earth, which serves as a universally available reference point. In some embodiments, "ground" does not refer to a physical connection to the Earth but rather to a point that is designated as the zero-voltage reference for the circuit. Optionally, an electrical reference net is a grounded layer of metal. A reference net or plane in a printed circuit board (PCB) design or in a substrate of a circuit die is a grid or a layer of conductive material (usually copper) that acts as a common return path for current and a reference voltage level. It can also provide a continuous, low-impedance path for the return of high-frequency signals, which can help reduce noise and electromagnetic interference (EMI).

The PIC 100 is stacked up on the EIC 200 by directly bonded the second group of electrical contacts on the third surface 3 via solders 160 to the first group of electrical contacts on the second surface 2. Thus, modulator 130 in PIC 100 would perform its signal modulation function based on driving signal delivered from Tx driver subcircuit 230 in EIC 200. Rx amplifier subcircuit 240 would also perform its amplification function to electrical signals output from photodiode 140. Here is just a simplified description for a single signal transmission/receiving (Tx-Rx) channel for the device. Optionally, there are multiple Tx-Rx channels of transmitters and receivers. Optionally, the modulator design employs a transmission line of a finite length at a certain characteristic impedance. Depending on the manufacturing process, this transmission line may be unshielded. Such unshielded transmission line often causes electric and magnetic fields which can permeate through the three-dimensional stack of PIC-over-EIC in all three directions. The lateral spreading of electromagnetic field in the X and Y dimensions could possibly be terminated by those conducting vias on the reference net. In the Z direction the electromagnetic field induced by some active components including transmitter subcircuit, however, may propagate unhindered in the PIC bulk silicon substrate 101 or beyond to generate electrical crosstalk with other subcircuits in the PIC including receiver subcircuit that has sensitive circuitry like photodiode. For PIC with co-packaged subcircuits, not limited to just transmitter or receiver subcircuits, proper electrical shielding would be critical to suppress high frequency electrical coupling between the closely packaged subcircuits.

For general purpose, the term "integrated circuit (IC)" mentioned here in the specification (or maybe simplified as "circuit") refers to a miniature electronic device that incorporates various electronic components, such as transistors, diodes, resistors, and capacitors, onto a single semiconductor substrate configured with a one or more functions. It refers typically to an electronic IC or EIC, also commonly known as a microchip or chip. A "photonic integrated circuit (PIC)" is a miniaturized electronic device that integrates specifically various photonic components and functions onto a single chip. Similar to EIC, photonic integrated circuits provide compact and highly integrated solutions for controlling and manipulating light signals. It typically incorporates a combination of active and passive optical components, including lasers, modulators, detectors, waveguides, splitters, couplers, filters, and other optical elements. Either EIC or PIC may include multiple subcircuits co-packaged in the same chip. A "subcircuit" refers to one unit device with a specific function configured within the "circuit". For example, a "transmitter subcircuit" refers to a unit device of PIC that performs light transmission which includes functions like light signal generation (laser), signal modulation, power amplification, wavelength division, or others. A subcircuit of a PIC may be coupled with a subcircuit of an EIC, for example, a modulator in the transmitter subcircuit may need a driver subcircuit in the EIC to allow digital signals, i.e., data, to be properly transmitted via the light signals. An Rx amplifier subcircuit in the EIC may receive and process electrical signal delivered from a photodiode converting a light signal to the electrical signal in the PIC. As multiple subcircuits are co-packaged in one PIC chip, crosstalk between these subcircuits, especially for some subcircuits that generate high-frequency electric field to interfere sensitive detection circuitry in some other subcircuits.

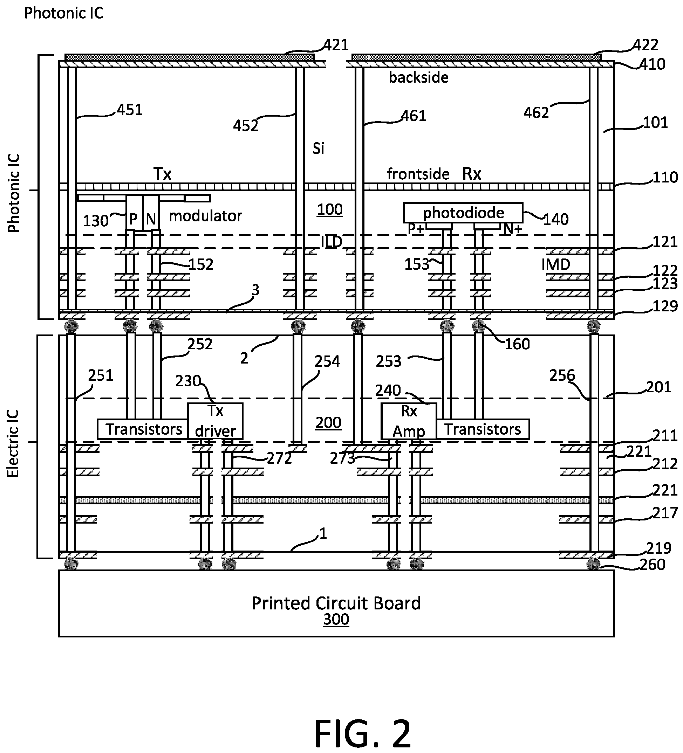

Figure 2 is a schematic diagram of a photonic integrated circuit with an electromagnetic shield based on through-silicon-vias and backside metallization stacking up on an electronic integrated circuit according to some embodiments of the subject technology. This diagram is merely an example, which should not unduly limit the scope of the claims. One of ordinary skill in the art would recognize many variations, alternatives, and modifications. FIG. 2 shows an improved layout of the silicon photonics device of FIG. 1 with an electromagnetic shield based on through-silicon-vias and backside metallization. As mentioned, there has been a reference net formed between the circuit layer and the third surface of the PIC 100. This reference net covers areas of both the first and second photonic subcircuits in X-Y dimensions across the PIC chip. The reference net may be connected to a single ground connection. Optionally, the reference net can be separated into two sections. The first section may be located in an area associated with the first photonic subcircuit and the second section may be located in an area associated with the second photonic subcircuit. Optionally, the first section of the reference net and the second section of the reference net can be separately grounded. Either way, the reference net may serve as a base for forming an electrical shield for either one or both of the first photonic subcircuit and the second photonic subcircuit to suppress the electromagnetic crosstalk between them.

For example, multiple vias 451, 452, 461, 462 are formed from the backside of the silicon substrate 101 to perpendicularly penetrate through the silicon substrate to reach the metal layer of the reference net. Before forming these through-silicon vias, the silicon substrate 101 can be thinned down to about the same thickness, e.g., 65 um, as the EIC 200. After the vias are formed through a series of masking, lithographing, etching, and cleaning processes, they can be filled with metal materials to be electrically conductive and be able to share the same potential with the reference net, e.g., being commonly grounded. In an embodiment, these vias are formed with selected locations such that a first plurality of vias, like via 451 and via 452, is configured to surround the first photonic subcircuit including at least the modulator 130 and a second plurality of vias, like via 461 and via 462, is configured to surround the second photonic subcircuit including at least the photodiode 140. In an embodiment, these vias are not necessarily physically next to each other to form a solid wall, instead, are formed with a certain via-to-via pitch distance. Depending on the types of photonics circuits and applications, the electrical electromagnetic interference between the different subcircuits may have different frequency of concerns. For example, the transmission line-based modulator may cause electromagnetic interference (EMI) to neighboring light detection circuitry mostly at frequency range from 13GHz to 25GHz. Based on fiber optic transceivers, the common bandwidths range from 5 GHz to 30 GHZ. These frequency ranges correspond to wavelengths greater than 10 mm. If the via pitch distance is set to as small as 1 mm, i.e., about 10% of the EMI wavelength, these vias can effectively block the EMI field spreading. In X-Y dimensions, the first plurality of vias (e.g., vias 451, vias 452) effectively forms a wall of shield surrounding the first photonic subcircuit and the second plurality of vias (e.g., vias 361, vias 462) also effectively forms a wall of shield surrounding the second photonic subcircuit.

Further referring to FIG. 2, a conductive layer 410 can be formed on the backside of the silicon substrate 101. The conductive layer 410 can be formed by depositing a metal material like Cu or Al or a CuAl alloy about 0.5 um in thickness. The conductive layer 410 may be formed by doping a layer of Si at the backside of the silicon substrate 101 with high electronic impurity. Usually, a barrier layer may be deposited first on the backside of the silicon substrate before forming conductive layer 410. The barrier layer prevents downward diffusion of the metal material into the silicon substrate. The barrier layer at corresponding spots where each via (e.g., via 452) is located on the backside can be etched away to allow the conductive layer 410 to form electrical contacts with the filled metal material in the vias. Therefore, the conductive layer 410 provides an electrical shield in Z-dimension. Combining the conductive layer with the first plurality of vias and the reference net, a first electrical shielding cage is formed fully covering the first photonic subcircuit and extending into bulk region of silicon substrate 101. The conductive layer 410 along with the second plurality of vias and the reference net also forms a second electrical shielding cage to cover the second photonic subcircuits entirely including bulk region extended into the bulk silicon substrate 101.

Optionally, the conductive layer 410 can be separated to two sections, a first section is associated with the first electrical shielding cage only for shielding the first photonic subcircuit and a second section is associated with the second electrical shielding cage for shielding the second photonic subcircuit. In some embodiments, two metal plates can be added to couple with the two sections of the conductive layer 410. A first metal plate 421 is attached to the first section of the conductive layer, and a second metal plate 422, isolated from the first metal plate 421, can be attached to the second section of the conductive layer. This is also compatible with the optional setup of two separate reference nets as suggested in some embodiments. Then, the two electrical shielding cages can be independently grounded. The grounded metal plate 421 can effectively terminate the electromagnetic fields to prevent the EMI field spreading from the first subcircuit (e.g., the modulator with transmission line) into the neighboring second subcircuit (e.g., the photodiode). For example, it may be advantageous to have an "Rx GND" and a "Tx GND" reference net in the PIC as well as EIC. In some embodiments, the reference nets in the system (if it is set in the printed circuit board) would be connected together to have one common ground.

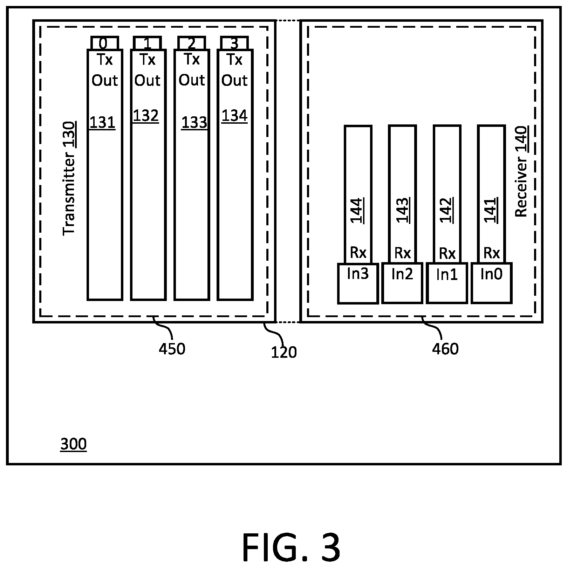

Figure 3 is a schematic top view of a photonic integrated circuit comprising co-packaged transmitter and receiver according to an embodiment of the subject technology. This diagram is merely an example, which should not unduly limit the scope of the claims. One of ordinary skill in the art would recognize many variations, alternatives, and modifications. FIG. 3 shows an example of a silicon photonics device in a chip having a PIC stacked up on an EIC mounted on a printed circuit board 300. In the top view, only the PIC is visible, which includes a transmitter subcircuit 130 and a receiver subcircuit 140, as an example. The transmitter 130 has four channels of transmission lines denoted as 131, 132, 133, and 134, respectively. Each transmission line is associated with an output terminal, respectively denoted as TxOut0, TxOut1, TxOut2, and Txout3 for channels 1 - 4. The electromagnetic interference produced by an optical transmitter is typically in the form of radiated electromagnetic fields rather than conducted interference. The strength of the radiated electromagnetic interference (EMI) depends on factors such as the power levels, channel frequencies involved, proximity to other devices, and the surrounding environment. The electrical signals that drive the modulator can generate EMI, particularly at higher frequencies. The transmission output terminal, where the electrical signal is converted into an optical signal, can be a major source of EMI radiation. Therefore, it is crucial to have an electromagnetic shield to enclose at least these Tx output terminals to prevent the electromagnetic field will not spread out to affect other subcircuits in the same silicon photonics device package.

The receiver 140 also has 4 channels each including at least a photodiode, e.g., 141, 142, 143, and 144. The photodiode is very sensitive to the EMI caused by the other circuits nearby. Particularly, at the optical input terminals, denoted as RxIn0, RxIn1, RxIn2, and RxIn3. The optical input terminal of a receiver is typically designed to detect and amplify weak optical signals. EMI can introduce additional noise or interference, reducing the receiver's sensitivity and potentially degrading its ability to accurately detect and interpret the incoming signal. EMI can increase the noise floor of the receiver, decreasing the overall signal-to-noise ratio. This can impact the receiver's ability to distinguish the desired signal from unwanted noise, leading to a degradation in the quality and reliability of the received data. High levels of EMI can result in errors in the received data stream, increasing the bit error rate of the system. This can lead to data corruption, loss of synchronization, and decreased overall system performance. Therefore, it is important to have an electromagnetic shield to enclose at least the Rx input terminals to prevent the environmental electromagnetic field especially generated by neighboring subcircuits from interfering the performance of the receiver subcircuit.

Referring to FIG. 3, to provide the electromagnetic shields that match the need for either the transmitter 130 or receiver 140, a reference net 120, formed under the circuit plane of the silicon photonics device in the chip on PCB, can be utilized. The reference net 120 is made by one or more of multiple metal layers separated by inter-metal dielectric. The multiple metal layers are also used for forming one or more electrical distributions or to help link circuit electrodes through some conducting vias to connect to metal contacts on the chip surface for bonding with another chip or printed circuit board. The reference net 120 can be electrically grounded to provide an electrical field terminator. Optionally, the reference net 120 can have two halves, one being under the transmitter 130 and another being under the receiver 140. Optionally, the two reference nets can be separately grounded, e.g., Tx GND for one and Rx GND for another, to make them fully isolated from each other.

Additionally, in vertical direction (perpendicular to the reference net 120), a shielding structure can be formed, with the purpose of surrounding at least the transmitter 130 or the receiver 140. In an embodiment, the shielding structure is a plurality of conductive columns laid along the dashed line shown in FIG. 3. As the real chip portion above the transmitter 130 and the receiver 140 is bulk silicon of a silicon substrate used for the silicon photonics device, the plurality of conductive columns in fact are a plurality of through-silicon-vias (TSV) filled by metal material. Accordingly, a first shield 450 is formed by a first plurality of conductive vias together with the reference net 120 below to fully surround the transmitter 130 especially the four TxOut terminals. A second shield 460 is formed by a second plurality of conductive vias together with the reference net 120 below to fully surround the receiver 140 including the four RxIn terminals. Since the frequency of concern in the Tx-Rx crosstalk EMI is in a range of 13-25GHz corresponding to wavelength range greater than 10 mm, the plurality of vias with a pitch distance of 1 mm or smaller can be sufficient to block the EMI.

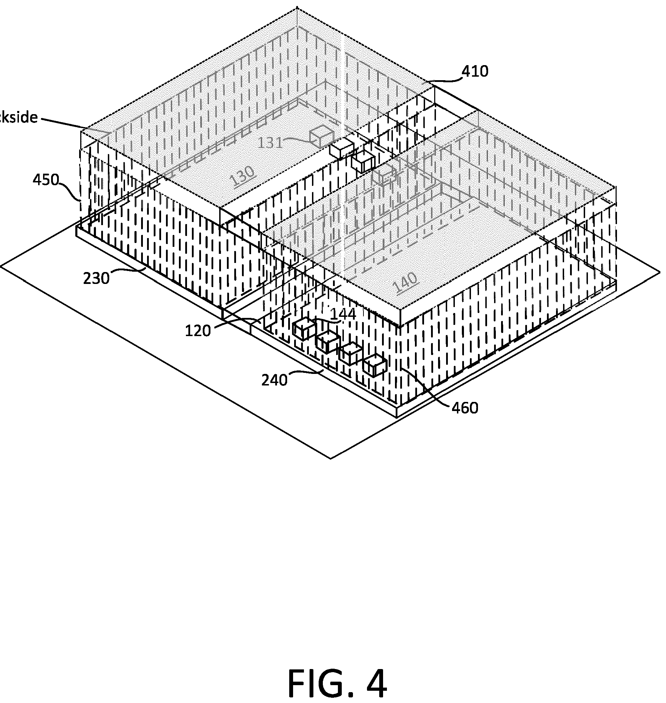

Figure 4 is a schematic perspective view of the electromagnetic shield based on through-silicon-vias and backside metallization according to an embodiment of the subject technology. This diagram is merely an example, which should not unduly limit the scope of the claims. One of ordinary skill in the art would recognize many variations, alternatives, and modifications. FIG. 4 provides another visual illustration of the electromagnetic shield based on through-silicon-vias and backside metallization for the silicon photonics device packaged with 3D stacking of a photonic integrated circuit on an electronic integrated circuit. As shown, the electronic integrated circuit includes two subcircuits 230 and 240 being disposed of at lower portion of the stacked package. The photonic integrated circuit, which is based on a silicon substrate, includes two subcircuits 130 and 140 respectively located above the two subcircuits 230 and 240 of the electronic integrated circuit. Photonic subcircuit 130 in the photonic integrated circuit includes at least a 4-ch transmitter with four Tx output terminals 131. Photonic subcircuit 140 in the photonic integrated circuit includes at least a 4-ch receiver with four Rx input terminals 144.

In some embodiments, an electromagnetic shielding cage for this silicon photonics device is provided by, 1) setting a reference net 120 under the photonics subcircuits to be electrically grounded; 2) forming a plurality of vias 450 and 460 (with locations indicated schematically by dashed lines in FIG. 4) penetrating the silicon substrate from the backside thereof to couple with the reference net 120 and respectively surround the photonic subcircuit 130 and photonic subcircuit 140; 3) filling the plurality of vias 450 and 460 to establish electrical potential unity with the reference net; 4) forming a conductive layer 410 overlying the backside of the silicon substrate to form two electromagnetic shielding cage enclosing respectively the photonic subcircuit 130 and photonic subcircuit 140. In particular, the shielding cage (450) shall fully terminate the spreading electromagnetic field induced by the Tx output terminals 131 of the photonic subcircuit 130 and prevent the electromagnetic field from interfering with the Rx input terminals 144 of the photonic subcircuit 140.

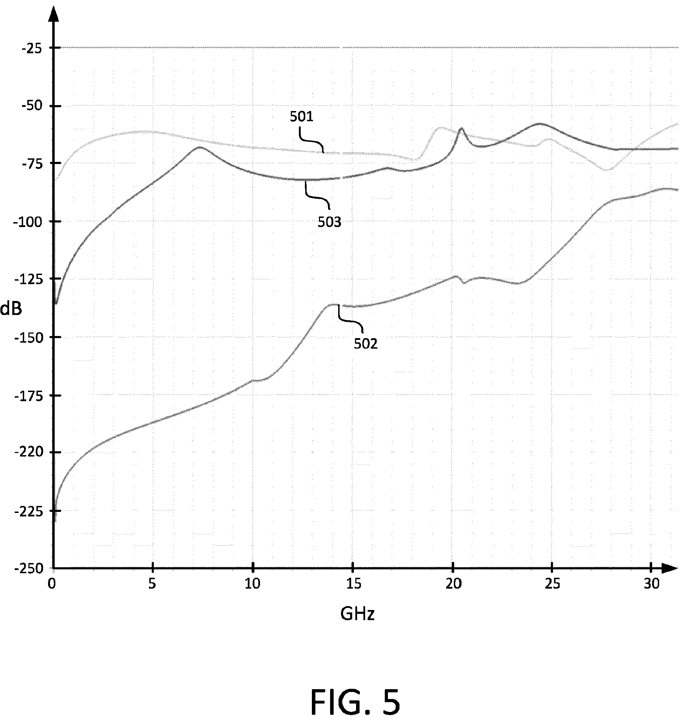

Figure 5 is plots of crosstalk isolation comparison for one Tx-Rx channel in three shielding models according to some embodiments of the subject technology. This diagram is merely an example, which should not unduly limit the scope of the claims. One of ordinary skill in the art would recognize many variations, alternatives, and modifications. FIG. 5 shows simulation results of crosstalk isolation for one channel Tx Output to Rx Input based on three electric shielding models.

Curve 501 corresponds to a model without shielding (at least in Z direction) for a silicon photonic device with 3D stacking of a photonic IC on an electronic IC (see FIG. 1). The frequency of concern is in the range of 13 GHz to 25 GHz. The simulation result indicates that the isolation between the Tx Output and Rx Input in one transmission/receiving channel is around -75dB across the frequency range of 13 - 25 GHz.

Curve 502 corresponds to a model with an electromagnetic shield based on conductive vias and backside metallization for a same kind of silicon photonics device (see FIG. 2). The simulation result, as shown by Curve 502, yields a much better isolation varied from -135 dB to -125 dB, suggesting that the electromagnetic shielding structure according to embodiments of the subject technology effectively suppresses and contains the electromagnetic interference between the Tx Output and Rx Input of the photonic integrated circuit. A 2D mapping (not shown) of the field spreading by the Tx Output shows that the electric field is basically terminated at the boundary of a first shielding cage (450, see FIG. 4) for the Tx Output and no field spreading is found in the shielding cage (460, see FIG. 4) for the Rx Input.

Curve 503 corresponds to a reference model without full shielding but just an RF absorber being placed on the backside of the silicon substrate of the photonic integrated circuit. The results suggest that the added RF absorber provides only a small improvement in crosstalk isolation. A 2D field mapping for this model (not shown) also indicates that there is still substantial field spreading from the Tx Output to Rx Input. This proves that the method and structure for shielding Tx-Rx crosstalk in photonic integrated circuit in this disclosure effectively suppresses high frequency electrical coupling between two photonic subcircuits like a transmitter and a receiver at a very fundamental level.

While the above is a full description of the specific embodiments, various modifications, alternative constructions and equivalents may be used. Therefore, the above description and illustrations should not be taken as limiting the scope of the invention which is defined by the appended claims.

## Claims

1. An integrated circuit device comprising:
a printed circuit board (300) ,PCB;
a first circuit (200) on a first substrate (101) comprising a first surface (1) and a second surface (2), the first surface (1) being coupled to the PCB (300), the second surface (2) comprising a first plurality of contacts (160) coupled to the first circuit (200);
a second circuit (100) on a second substrate (101) comprising a third surface (3) and a fourth surface, the second circuit (100) being disposed on the first circuit (200), the second circuit (100) comprising at least a first component (130) and a second component (140), the third surface (3) comprising a second plurality of contacts (129) coupled to the first component (130) and the second component (140), the second plurality of contacts (129) being coupled to the first plurality of contacts (160);
a layer of conductive material (410) disposed on the fourth surface;
a metal layer (121, 122, 123) disposed in a dielectric between the first component (130) and the third surface (3);
a first plurality of vias (451, 452) extended from the fourth surface through the second substrate (101) to at least partially surround the first component (130), the first plurality of vias (451, 452) being coupled to the layer of conductive material (410) and the metal layer (121, 122, 123);and
a second plurality of vias (461, 462) extended from the fourth surface through the second substrate (101) to at least partially surround the second component (140), the second plurality of vias (461, 462) being coupled to the layer of conductive material (410) and the metal layer (121, 122, 123).

2. The device of claim 1, comprising at least one of the following features:
wherein the first component (130) comprises at least one of optical transmitter, laser, optical amplifier, and optical modulator;
wherein the second component (140) comprises at least one of photodetector, optical receiver, and optical sensor.

3. The device of claim 1 or 2, further comprising an electrical reference net (120) based on the metal layer (121, 122, 123) with a single ground connection.

4. The device of any of claims 1 to 3, wherein the metal layer (121, 122, 123) comprises a first grounded layer at least partially covering an area of the first component (130) and a second grounded layer at least partially covering an area of the second component (140), the first grounded layer and the second grounded layer being isolated and having independent ground connections.

5. The device of any of claims 1 to 4, comprising at least one of the following features:
further comprising a barrier layer disposed between the fourth surface and the layer of conductive material (410);
wherein the layer of conductive material (410) comprises a layer of Cu or Al or an alloy of Cu and Al or a layer of heavily doped silicon.

6. The device of any of claims 2 to 5, wherein the first plurality of vias (451, 452) or the second plurality of vias (461, 462) comprises a via-to-via pitch separation smaller than 1 mm for achieving at least -125dB isolation between the first component (130) and the second component (140) from the electromagnetic interference with a characteristic frequency up to 30 GHz.

7. The device of any of claims 1 to 6, further comprising a metal plate (421, 422) coupled onto the layer of conductive material (410) on the fourth surface and electrically grounded.

8. The device of any of claims 4 to 7, further comprising a first metal plate (421) on a first portion of the fourth surface coupled to the first plurality of vias (451, 452) and the first grounded layer for shielding the first component (130), and a second metal plate (422) on a second portion of the fourth surface coupled to the second plurality of vias (461, 462) and the second grounded layer for shielding the second component (140), the second metal (422) plate being decoupled from the first metal plate (421).

9. A method for suppressing electrical coupling in a photonics integrated circuit, the method comprising:
providing a substrate (101) comprising a first surface (3) and the second surface, the second surface being opposite to the first surface (3);
packaging a first photonic component (130) and a second photonic component (140) on the first surface (3), the first photonic component (130) comprising at least a light transmitter, the second photonic component (140) comprising at least a light detector;
forming an electrical reference net (120) based on at least one metal layer (121, 122, 123) positioned in a dielectric, the dielectric at least partially covering the light transmitter and the light detector;
forming a first plurality of vias (451, 452) through the substrate (101) from the second surface to couple to the electrical reference net (120), the first plurality of vias (451, 452) being disposed to at least partially surround the light transmitter; and
forming a conductive layer (410) on the second surface of the substrate (101), the conductive layer (410) being coupled to the first plurality of vias (451, 452) and the electrical reference net (120) to form an electrical shield for the first photonic component (130).

10. The method of claim 9, comprising at least one of the following features:
further comprising forming a second plurality of vias (461, 462) through the substrate (101) from the second surface to couple to the electrical reference net (120), the second plurality of vias (461, 462) being disposed to at least partially surround the light detector;
further comprising forming a second conductive layer on the second surface of the substrate (101) to couple to the second plurality of vias (461, 462) and the electrical reference net (120) to form an electrical shield for the second photonic component (140);
wherein forming the electrical reference net (120) comprises forming a first reference net (120) at least partially covering an area associated with the light transmitter, and forming a second reference net (120) at least partially covering an area associated with the light detector, the first reference net (120) and the second reference net (120) being isolated from each other and separately grounded.

11. The method of claim 9 or 10, further comprising forming at least one first metal contact and at least one second metal contact on the first surface (3), the at least one first metal contact being arranged to couple to the light transmitter and the at least one second metal contact being arranged to couple to the light detector.

12. The method of claim 11, further comprising coupling the at least one first metal contact and the at least one second metal contact respectively to corresponding contacts of an electronic integrated circuit.

13. A photonics integrated device with electromagnetic shielding comprising:
a substrate (101) with a first surface (3) and a second surface, the second surface being opposite to the first surface (3);
a circuit formed on the first surface (3), the circuit comprising at least a first component (130) and a second component (140), the first component (130) comprising at least a light transmitter, the second component (140) comprising at least a light detector;
a metal layer (121, 122, 123) disposed in a dielectric on the first surface (3), the metal layer (121, 122, 123) being an electrical reference with a grounded connection;
a first plurality of vias (451, 452) from the second surface through the substrate (101), the first plurality of vias (451, 452) being configured to couple to the electrical reference and to at least partially surround the first component (130);
a second plurality of vias (461, 462) from the second surface through the substrate (101), the second plurality of vias (461, 462) being configured to couple to the electrical reference and to at least partially surround the second component (140); and
a conductive layer (410) disposed on the second surface of the substrate (101), the conductive layer (410) being coupled to the first plurality of vias (451, 452) and the second plurality of vias (461, 462) to form a first electromagnetic shield and a second electromagnetic shield respectively for the first component (130) and the second component (140).

14. The device of claim 13, wherein the first plurality of vias (451, 452) and the second plurality of vias (461, 462) comprise a via-to-via pitch separation smaller than 1 mm to achieving -125dB isolation between the light transmitter and the light detector from the electromagnetic interference with characteristic frequencies up to 30GHz.

15. The device of claim 13 or 14, comprising at least one of the following features:
wherein the metal layer (121, 122, 123) comprises a first section and a second section being separately grounded and respectively coupled with the first plurality of vias (451, 452) and the second plurality of vias (461, 462);
wherein the conductive layer (410) comprises a first portion and a second portion respectively coupled with the first section and the second section to be associated with the first electromagnetic shield and the second electromagnetic shield respectively, the first electromagnetic shield being decoupled from the second electromagnetic shield.

## Patentansprüche

1. Eine integrierte Schaltkreisvorrichtung, aufweisend:
eine gedruckte Leiterplatte (300), PCB;
einen ersten Schaltkreis (200) auf einem ersten Substrat (101), aufweisend eine erste Oberfläche (1) und eine zweite Oberfläche (2), wobei die erste Oberfläche (1) mit der PCB (300) gekoppelt ist, wobei die zweite Oberfläche (2) eine erste Mehrzahl von Kontakten (160) aufweist, die mit dem ersten Schaltkreis (200) gekoppelt sind;
einen zweiten Schaltkreis (100) auf einem zweiten Substrat (101), aufweisend eine dritte Oberfläche (3) und eine vierte Oberfläche, wobei der zweite Schaltkreis (100) auf dem ersten Schaltkreis (200) angeordnet ist, wobei der zweite Schaltkreis (100) zumindest eine erste Komponente (130) und eine zweite Komponente (140) aufweist, wobei die dritte Oberfläche (3) eine zweite Mehrzahl von Kontakten (129) aufweist, die mit der ersten Komponente (130) und der zweiten Komponente (140) gekoppelt sind, wobei die zweite Mehrzahl von Kontakten (129) mit der ersten Mehrzahl von Kontakten (160) gekoppelt ist;
eine Schicht aus leitfähigem Material (410), die auf der vierten Oberfläche angeordnet ist;
eine Metallschicht (121, 122, 123), die in einem Dielektrikum zwischen der ersten Komponente (130) und der dritten Oberfläche (3) angeordnet ist;
eine erste Mehrzahl von Vias (451, 452), die sich von der vierten Oberfläche durch das zweite Substrat (101) erstrecken, um die erste Komponente (130) zumindest teilweise zu umgeben, wobei die erste Mehrzahl von Vias (451, 452) mit der Schicht aus leitfähigem Material (410) und der Metallschicht (121, 122, 123) gekoppelt ist; und
eine zweite Mehrzahl von Vias (461, 462), die sich von der vierten Oberfläche durch das zweite Substrat (101) erstrecken, so dass sie die zweite Komponente (140) zumindest teilweise umgeben, wobei die zweite Mehrzahl von Vias (461, 462) mit der Schicht aus leitfähigem Material (410) und der Metallschicht (121, 122, 123) gekoppelt ist.

2. Die Vorrichtung gemäß Anspruch 1, aufweisend zumindest eines der folgenden Merkmale:
wobei die erste Komponente (130) zumindest eines von einem optischen Sender, einem Laser, einem optischen Verstärker und einem optischen Modulator aufweist;
wobei die zweite Komponente (140) zumindest eines von einem Photodetektor, einem optischen Empfänger und einem optischen Sensor aufweist.

3. Die Vorrichtung gemäß Anspruch 1 oder 2, ferner aufweisend ein elektrisches Referenznetz (120) basierend auf der Metallschicht (121, 122, 123) mit einer einzelnen Masseverbindung.

4. Die Vorrichtung gemäß einem der Ansprüche 1 bis 3, wobei die Metallschicht (121, 122, 123) eine erste mit Masse verbundene Schicht, die zumindest teilweise einen Bereich der ersten Komponente (130) bedeckt, und eine zweite mit Masse verbundene Schicht, die zumindest teilweise einen Bereich der zweiten Komponente (140) bedeckt, aufweist, wobei die erste mit Masse verbundene Schicht und die zweite mit Masse verbundene Schicht isoliert sind und unabhängige Masseverbindungen aufweisen.

5. Die Vorrichtung gemäß einem der Ansprüche 1 bis 4, aufweisend zumindest eines der folgenden Merkmale:
ferner aufweisend eine Barriereschicht, die zwischen der vierten Oberfläche und der Schicht aus leitfähigem Material (410) angeordnet ist;
wobei die Schicht aus leitfähigem Material (410) eine Schicht aus Cu oder Al oder eine Legierung aus Cu und Al oder eine Schicht aus stark dotiertem Silizium aufweist.

6. Die Vorrichtung gemäß einem der Ansprüche 2 bis 5, wobei die erste Mehrzahl von Vias (451, 452) oder die zweite Mehrzahl von Vias (461, 462) einen Via-zu-Via-Abstand von kleiner als 1 mm aufweist, um zumindest eine -125 dB Isolation zwischen der ersten Komponente (130) und der zweiten Komponente (140) von der elektromagnetischen Interferenz mit einer charakteristischen Frequenz bis zu 30 GHz zu erreichen.

7. Die Vorrichtung gemäß einem der Ansprüche 1 bis 6, ferner aufweisend eine Metallplatte (421, 422), die auf die Schicht aus leitfähigem Material (410) auf der vierten Oberfläche gekoppelt und elektrisch mit Masse verbunden ist.

8. Die Vorrichtung gemäß einem der Ansprüche 4 bis 7, ferner aufweisend eine erste Metallplatte (421) auf einem ersten Abschnitt der vierten Oberfläche, die mit der ersten Mehrzahl von Vias (451, 452) und der ersten mit Masse verbundenen Schicht gekoppelt ist, zum Abschirmend der ersten Komponente (130), und eine zweite Metallplatte (422) auf einem zweiten Abschnitt der vierten Oberfläche, die mit der zweiten Mehrzahl von Vias (461, 462) und der zweiten mit Masse verbundenen Schicht gekoppelt ist, zum Abschirmen der zweiten Komponente (140), wobei die zweite Metallplatte (422) von der ersten Metallplatte (421) entkoppelt ist.

9. Ein Verfahren zum Unterdrücken einer elektrischen Kopplung in einem integrierten Photonik-Schaltkreis, wobei das Verfahren aufweist:
Bereitstellen eines Substrats (101), aufweisend eine erste Oberfläche (3) und die zweite Oberfläche, wobei die zweite Oberfläche der ersten Oberfläche (3) gegenüberliegt;
Verpacken einer ersten photonischen Komponente (130) und einer zweiten photonischen Komponente (140) auf der ersten Oberfläche (3), wobei die erste photonische Komponente (130) zumindest einen Lichtsender aufweist, wobei die zweite photonische Komponente (140) zumindest einen Lichtdetektor aufweist;
Bilden eines elektrischen Referenznetzes (120) basierend auf zumindest einer Metallschicht (121, 122, 123), die in einem Dielektrikum positioniert ist, wobei das Dielektrikum zumindest teilweise den Lichtsender und den Lichtdetektor bedeckt;
Bilden einer ersten Mehrzahl von Vias (451, 452) durch das Substrat (101) von der zweiten Oberfläche, um mit dem elektrischen Referenznetz (120) zu koppeln, wobei die erste Mehrzahl von Vias (451, 452) so angeordnet ist, dass sie den Lichtsender zumindest teilweise umgeben; und
Bilden einer leitfähigen Schicht (410) auf der zweiten Oberfläche des Substrats (101), wobei die leitfähige Schicht (410) mit der ersten Mehrzahl von Vias (451, 452) und dem elektrischen Referenznetz (120) gekoppelt ist, um eine elektrische Abschirmung für die erste photonische Komponente (130) zu bilden.

10. Das Verfahren gemäß Anspruch 9, aufweisend zumindest eines der folgenden Merkmale:
ferner aufweisend Bilden einer zweiten Mehrzahl von Vias (461, 462) durch das Substrat (101) von der zweiten Oberfläche, um mit dem elektrischen Referenznetz (120) zu koppeln, wobei die zweite Mehrzahl von Vias (461, 462) so angeordnet ist, dass sie den Lichtdetektor zumindest teilweise umgeben;
ferner aufweisend Bilden einer zweiten leitfähigen Schicht auf der zweiten Oberfläche des Substrats (101), um mit der zweiten Mehrzahl von Vias (461, 462) und dem elektrischen Referenznetz (120) zu koppeln, um eine elektrische Abschirmung für die zweite photonische Komponente (140) zu bilden;
wobei das Bilden des elektrischen Referenznetzes (120) aufweist Bilden eines ersten Referenznetzes (120), das zumindest teilweise einen Bereich bedeckt, der mit dem Lichtsender assoziiert ist, und Bilden eines zweiten Referenznetzes (120), das zumindest teilweise einen Bereich bedeckt, der mit dem Lichtdetektor assoziiert ist, wobei das erste Referenznetz (120) und das zweite Referenznetz (120) voneinander isoliert und separat mit Masse verbunden sind.

11. Das Verfahren gemäß Anspruch 9 oder 10, ferner aufweisend Bilden zumindest eines ersten Metallkontakts und zumindest eines zweiten Metallkontakts auf der ersten Oberfläche (3), wobei der zumindest eine erste Metallkontakt so angeordnet ist, dass er mit dem Lichtsender gekoppelt ist, und der zumindest eine zweite Metallkontakt so angeordnet ist, dass er mit dem Lichtdetektor gekoppelt ist.

12. Das Verfahren gemäß Anspruch 11, ferner aufweisend Koppeln des zumindest einen ersten Metallkontakts und des zumindest einen zweiten Metallkontakts jeweils mit entsprechenden Kontakten eines elektronischen integrierten Schaltkreises.

13. Eine integrierte Photonikvorrichtung mit elektromagnetischer Abschirmung, aufweisend:
ein Substrat (101) mit einer ersten Oberfläche (3) und einer zweiten Oberfläche, wobei die zweite Oberfläche der ersten Oberfläche (3) gegenüberliegt;
einen Schaltkreis, der auf der ersten Oberfläche (3) gebildet ist, wobei der Schaltkreis zumindest eine erste Komponente (130) und eine zweite Komponente (140) aufweist, wobei die erste Komponente (130) zumindest einen Lichtsender aufweist, wobei die zweite Komponente (140) zumindest einen Lichtdetektor aufweist;
eine Metallschicht (121, 122, 123), die in einem Dielektrikum auf der ersten Oberfläche (3) angeordnet ist, wobei die Metallschicht (121, 122, 123) eine elektrische Referenz mit einer Masseverbindung ist;
eine erste Mehrzahl von Vias (451, 452) von der zweiten Oberfläche durch das Substrat (101), wobei die erste Mehrzahl von Vias (451, 452) so konfiguriert sind, dass sie mit der elektrischen Referenz gekoppelt sind und die erste Komponente (130) zumindest teilweise umgeben;
eine zweite Mehrzahl von Vias (461, 462) von der zweiten Oberfläche durch das Substrat (101), wobei die zweite Mehrzahl von Vias (461, 462) so konfiguriert sind, dass sie mit der elektrischen Referenz gekoppelt sind und die zweite Komponente (140) zumindest teilweise umgeben; und
eine leitfähige Schicht (410), die auf der zweiten Oberfläche des Substrats (101) angeordnet ist, wobei die leitfähige Schicht (410) mit der ersten Mehrzahl von Vias (451, 452) und der zweiten Mehrzahl von Vias (461, 462) so gekoppelt sind, dass sie eine erste elektromagnetische Abschirmung bzw. eine zweite elektromagnetische Abschirmung für die erste Komponente (130) und die zweite Komponente (140) bilden.

14. Die Vorrichtung gemäß Anspruch 13, wobei die erste Mehrzahl von Vias (451, 452) und die zweite Mehrzahl von Vias (461, 462) einen Via-zu-Via-Abstand von kleiner als 1 mm aufweisen, um eine -125 dB Isolation zwischen dem Lichtsender und dem Lichtdetektor von der elektromagnetischen Interferenz mit charakteristischen Frequenzen bis zu 30 GHz zu erreichen.

15. Die Vorrichtung gemäß Anspruch 13 oder 14, aufweisend zumindest eines der folgenden Merkmale:
wobei die Metallschicht (121, 122, 123) eine erste Sektion und eine zweite Sektion aufweist, die separat mit Masse verbunden sind und jeweils mit der ersten Mehrzahl von Vias (451, 452) und der zweiten Mehrzahl von Vias (461, 462) gekoppelt sind;
wobei die leitfähige Schicht (410) einen ersten Abschnitt und einen zweiten Abschnitt aufweist, die jeweils mit der ersten Sektion und der zweiten Sektion gekoppelt sind, so dass sie mit der ersten elektromagnetischen Abschirmung bzw. der zweiten elektromagnetischen Abschirmung assoziiert sind, wobei die erste elektromagnetische Abschirmung von der zweiten elektromagnetischen Abschirmung entkoppelt ist.

## Revendications

1. Dispositif à circuit intégré, comprenant :
une carte de circuit imprimé (300), PCB ;
un premier circuit (200) sur un premier substrat (101) comprenant une première surface (1) et une deuxième surface (2), la première surface (1) étant couplée au PCB (300), la seconde surface (2) comprenant une première pluralité de contacts (160) couplés au premier circuit (200) ;
un second circuit (100) sur un second substrat (101) comprenant une troisième surface (3) et une quatrième surface, le second circuit (100) étant disposé sur le premier circuit (200), le second circuit (100) comprenant au moins un premier composant (130) et un second composant (140), la troisième surface (3) comprenant une seconde pluralité de contacts (129) couplés au premier composant (130) et au second composant (140), la seconde pluralité de contacts (129) étant couplée à la première pluralité de contacts (160) ;
une couche de matériau conducteur (410) disposée sur la quatrième surface ;
une couche de métal (121, 122, 123) disposée dans un diélectrique entre le premier composant (130) et la troisième surface (3) ;
une première pluralité de trous d'interconnexion (451, 452) s'étendant à partir de la quatrième surface à travers le second substrat (101) pour entourer au moins partiellement le premier composant (130), la première pluralité de trous d'interconnexion (451, 452) étant couplée à la couche de matériau conducteur (410) et à la couche de métal (121, 122, 123) ; et
une seconde pluralité de trous d'interconnexion (461, 462) s'étendant à partir de la quatrième surface à travers le second substrat (101) pour entourer au moins partiellement le second composant (140), la seconde pluralité de trous d'interconnexion (461, 462) étant couplée à la couche de matériau conducteur (410) et à la couche de métal (121, 122, 123).

2. Dispositif selon la revendication 1, comprenant au moins une des caractéristiques suivantes :
dans lequel le premier composant (130) comprend au moins un parmi un émetteur optique, un laser, un amplificateur optique et un modulateur optique ;
dans lequel le second composant (140) comprend au moins un parmi un photodétecteur, un récepteur optique et un capteur optique.

3. Dispositif selon la revendication 1 ou 2, comprenant en outre un réseau de référence électrique (120) basé sur la couche de métal (121, 122, 123) avec une connexion à la masse unique.

4. Dispositif selon l'une quelconque des revendications 1 à 3, dans lequel la couche de métal (121, 122, 123) comprend une première couche mise à la masse recouvrant au moins partiellement une zone du premier composant (130) et une seconde couche mise à la masse recouvrant au moins partiellement une zone du second composant (140), la première couche mise à la masse et la seconde couche mise à la masse étant isolées et présentant des connexions de masse indépendantes.

5. Dispositif selon l'une quelconque des revendications 1 à 4, comprenant au moins l'une des caractéristiques suivantes :
comprenant en outre une couche barrière disposée entre la quatrième surface et la couche de matériau conducteur (410) ;
dans lequel la couche de matériau conducteur (410) comprend une couche de Cu ou d'Al ou d'un alliage de Cu et d'Al ou une couche de silicium fortement dopé.

6. Dispositif selon l'une quelconque des revendications 2 à 5, dans lequel la première pluralité de trous d'interconnexion (451, 452) ou la seconde pluralité de trous d'interconnexion (461, 462) comprend une séparation de pas de trou d'interconnexion à trou d'interconnexion inférieure à 1 mm pour obtenir une isolation d'au moins -125 dB entre le premier composant (130) et le second composant (140) à partir de l'interférence électromagnétique avec une fréquence caractéristique allant jusqu'à 30 GHz.

7. Dispositif selon l'une quelconque des revendications 1 à 6, comprenant en outre une plaque de métal (421, 422) couplée sur la couche de matériau conducteur (410) sur la quatrième surface et mise à la masse électriquement.

8. Dispositif selon l'une quelconque des revendications 4 à 7, comprenant en outre une première plaque de métal (421) sur une première partie de la quatrième surface couplée à la première pluralité de trous d'interconnexion (451, 452) et à la première couche mise à la masse pour protéger le premier composant (130), et une seconde plaque de métal (422) sur une seconde partie de la quatrième surface couplée à la seconde pluralité de trous d'interconnexion (461, 462) et à la seconde couche mise à la masse pour protéger le second composant (140), la seconde plaque de métal (422) étant découplée de la première plaque de métal (421).

9. Procédé de suppression d'un couplage électrique dans un circuit intégré photonique, le procédé comprenant les étapes consistant à :
fournir un substrat (101) comprenant une première surface (3) et la deuxième surface, la deuxième surface étant opposée à la première surface (3) ;
conditionner un premier composant photonique (130) et un second composant photonique (140) sur la première surface (3), le premier composant photonique (130) comprenant au moins un émetteur de lumière, le second composant photonique (140) comprenant au moins un détecteur de lumière ;
former un réseau électrique de référence (120) sur la base d'au moins une couche de métal (121, 122, 123) positionnée dans un diélectrique, le diélectrique recouvrant au moins partiellement l'émetteur de lumière et le détecteur de lumière ;
former une première pluralité de trous d'interconnexion (451, 452) à travers le substrat (101) à partir de la deuxième surface pour un couplage au réseau de référence électrique (120), la première pluralité de trous d'interconnexion (451, 452) étant disposée pour entourer au moins partiellement l'émetteur de lumière ; et
former une couche conductrice (410) sur la deuxième surface du substrat (101), la couche conductrice (410) étant couplée à la première pluralité de trous d'interconnexion (451, 452) et au réseau de référence électrique (120) pour former un blindage électrique pour le premier composant photonique (130).

10. Procédé selon la revendication 9, comprenant au moins l'une des caractéristiques suivantes :
comprenant en outre la formation d'une seconde pluralité de trous d'interconnexion (461, 462) à travers le substrat (101) à partir de la deuxième surface pour un couplage au réseau de référence électrique (120), la seconde pluralité de trous d'interconnexion (461, 462) étant disposée pour entourer au moins partiellement le détecteur de lumière ;
comprenant en outre la formation d'une seconde couche conductrice sur la deuxième surface du substrat (101) pour un couplage à la seconde pluralité de trous d'interconnexion (461, 462) et au réseau de référence électrique (120) afin de former un blindage électrique pour le second composant photonique (140) ;
dans lequel la formation du réseau de référence électrique (120) comprend la formation d'un premier réseau de référence (120) couvrant au moins partiellement une zone associée à l'émetteur de lumière, et la formation d'un second réseau de référence (120) couvrant au moins partiellement une zone associée au détecteur de lumière, le premier réseau de référence (120) et le second réseau de référence (120) étant isolés l'un de l'autre et mis à la masse séparément.

11. Procédé selon la revendication 9 ou 10, comprenant en outre la formation d'au moins un premier contact métallique et d'au moins un second contact métallique sur la première surface (3), l'au moins premier contact métallique étant agencé pour un couplage à l'émetteur de lumière et l'au moins second contact métallique étant agencé pour un couplage au détecteur de lumière.

12. Procédé selon la revendication 11, comprenant en outre le couplage d'au moins un premier contact métallique et d'au moins un second contact métallique respectivement à des contacts correspondants d'un circuit intégré électronique.

13. Dispositif intégré photonique à blindage électromagnétique comprenant :
un substrat (101) avec une première surface (3) et une deuxième surface, la deuxième surface étant opposée à la première surface (3) ;
un circuit formé sur la première surface (3), le circuit comprenant au moins un premier composant (130) et un second composant (140), le premier composant (130) comprenant au moins un émetteur de lumière, le second composant (140) comprenant au moins un détecteur de lumière ;
une couche de métal (121, 122, 123) disposée dans un diélectrique sur la première surface (3), la couche de métal (121, 122, 123) étant une référence électrique avec une connexion à la masse ;
une première pluralité de trous d'interconnexion (451, 452) depuis la deuxième surface à travers le substrat (101), la première pluralité de trous d'interconnexion (451, 452) étant configurée pour un couplage à la référence électrique et pour entourer au moins partiellement le premier composant (130) ;
une seconde pluralité de trous d'interconnexion (461, 462) à partir de la deuxième surface à travers le substrat (101), la seconde pluralité de trous d'interconnexion (461, 462) étant configurée pour un couplage à la référence électrique et pour entourer au moins partiellement le second composant (140) ; et
une couche conductrice (410) disposée sur la deuxième surface du substrat (101), la couche conductrice (410) étant couplée à la première pluralité de trous d'interconnexion (451, 452) et à la seconde pluralité de trous d'interconnexion (461, 462) pour former un premier blindage électromagnétique et un second blindage électromagnétique respectivement pour le premier composant (130) et le second composant (140).

14. Dispositif selon la revendication 13, dans lequel la première pluralité de trous d'interconnexion (451, 452) et la seconde pluralité de trous d'interconnexion (461, 462) comprennent une séparation de pas de trou d'interconnexion à trou d'interconnexion inférieure à 1 mm pour obtenir une isolation de -125 dB entre l'émetteur de lumière et le détecteur de lumière par rapport à l'interférence électromagnétique avec des fréquences caractéristiques allant jusqu'à 30 GHz.

15. Dispositif selon la revendication 13 ou 14, comprenant au moins l'une des caractéristiques suivantes :
dans lequel la couche de métal (121, 122, 123) comprend une première section et une seconde section mises à la masse séparément et couplées respectivement à la première pluralité de trous d'interconnexion (451, 452) et à la seconde pluralité de trous d'interconnexion (461, 462) ;
dans lequel la couche conductrice (410) comprend une première partie et une seconde partie couplées respectivement à la première section et à la seconde section pour être associées au premier blindage électromagnétique et au second blindage électromagnétique respectivement, le premier blindage électromagnétique étant découplé du second blindage électromagnétique.
